Europäisches Patentamt

European Patent Office

Office européen des brevets

(19)

(11) Publication number: **0 110 317**
**B1**

(12) **EUROPEAN PATENT SPECIFICATION**

(45) Date of publication of patent specification: **29.03.89**

(51) Int. Cl.⁴: **H 03 K 5/02, H 03 K 19/086**

(21) Application number: **83111724.7**

(22) Date of filing: **23.11.83**

(54) **Small power consumption circuit for driving high-speed digital-signal transmission lines.**

(30) Priority: **24.11.82 IT 6836482**

(43) Date of publication of application:
**13.06.84 Bulletin 84/24**

(45) Publication of the grant of the patent:
**29.03.89 Bulletin 89/13**

(84) Designated Contracting States:
**DE FR GB NL SE**

(56) References cited:
**DE-A-3 135 952**
**FR-A-1 465 627**
**FR-A-2 409 640**
**US-A-3 978 347**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **Belforte, Piero**
**Via Fabbriche 7**
**Torino (IT)**

(74) Representative: **Riederer Freiherr von Paar zu Schönau, Anton et al**
**Van der Werth, Lederer & Riederer Freyung 615**
**Postfach 2664**
**D-8300 Landshut (DE)**

Courier Press, Leamington Spa, England.

## Description

The present invention concerns a driving circuit for high-speed digital-signal transmission lines as stated·in the prior art portion of Claims 1 or 2, and in particular it provides such driving circuit having a small power consumption. The driving circuit of the invention is particularly intended for digital signals at ECL logic levels (emitter coupled logic).

An integrated driving circuit for a transmission line is known e.g. from FR—A—1 465 627. DE—A—31 35 952 published on 21.04.1983 describes a combinatory switching gate using ECL techniques.

Conventional ECL driving circuits comprise a differential input stage and an output stage comprising a pair of common collector transistors the emitters of which supply, at the circuit output, both the high and the low logic level signals (balanced output). Such transistors are connected each to a bias current source (a current generator or a resistor) which supplies a constant current, high enough to prevent the transistors from being cut off even when they send a low-level signal on the line, i.e., when the transistors receive current from the line instead of sending current on the line. Owing to this high bias current, the power consumption of the transistors under stationary conditions is high. Moreover, also the maximum current a transistor is to supply when transmitting signals is considerably high, as such current is the sum of the signal current and the bias current. As a consequence, the transistors are to be dimensioned so as to be able to tolerate such high currents, what can also cause reliability problems. Power-consumption and dimensioning problems are particularly critical when the driving circuit is to be inserted into an integrated circuit, e.g. together with a signal transceiver.

For reducing the power-consumption under stationary conditions, it is known to provide a switching circuit between the common collector transistors and the current generator thereof, this switching circuit connecting the current generator at a certain instant to the transistor that issues the low-level signal on the line. Such switching circuit is constituted of transistors which are to be conveniently controlled to be conductive or blocking.

For a circuit used as an intermediate stage in a decoder for a store, it is known from FR—A—2 409 640 that such switching circuit transistors are controlled through cross-coupling from the collector of the other one each of these transistors, or are controlled by second-emitter branches from the respectively other one of the common-collector transistors. Thus, the transistors form a bistable circuit, that is a circuit with feedback, such bistable circuit being unsuitable for the output stage of a driver intended to be connected to high-speed transmission lines between integrated circuits, as the reflections on the lines could cause spurious switchings of the bistable circuit. Further, it would seem desirable to avoid that the switching transistors come into saturation.

Thus, the invention is directed to measures allowing a high-speed driving of digital-signal transmission lines while inhibiting the saturation of the switching transistors.

This aim is achieved by the driving circuit of the invention, characterized in two alternative embodiments in Claims 1 and 2. By these embodiments, the switching circuit transistors, i.e. the fifth and sixth transistors, are controlled from the input stage through two external diodes, thus resulting in a differential structure without feedback. By suitably dimensioning the circuit, the switching transistors can effectively be inhibited from becoming saturated.

Further, the driving circuit can be used with lines requiring voltage levels shifted with respect to the conventional ECL levels.

To make the invention more understandable, reference is made to the annexed drawings in which:

Figure 1 is a schematic diagram of a conventional ECL driving circuit;

Figures 2, 3 are circuit diagrams of two embodiments of the invention.

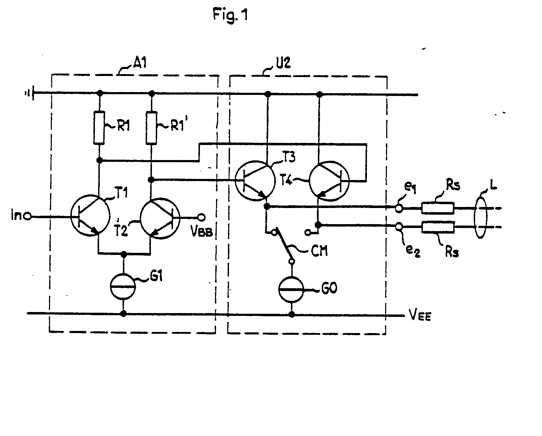

As shown in Figure 1, a conventional ECL circuit for driving high-speed digital lines comprises an input differential stage (or switching circuit) A1 as well as an output stage U2 which provides two signals with opposite logic-level (balanced output).

Input stage A1 consists of two transistors T1, T2 with collector resistors R1, R1', and of current generator G1. The base of T1 is connected to the signal input In and the base of T2 is connected to a voltage $V_{BB}$ intermediate between the voltages corresponding to high and low logic levels.

Output stage U2 comprises two common-collector transistors T3, T4, having the bases connected to the collectors of T1, T2 and the emitters connected to the circuit outputs e1, e2; these are in turn connected to a balanced line L, whose termination resistors are shown at $R_S$. The emitters of T3, T4 are in turn connected to supply voltage $V_{EE}$ through switching circuit CM and a common source of bias current I0, schematized by a current generator G0.

During transmission, switching circuit CM connects generator G0 to the transistor that at a certain instant sends the low-level signal on the line, and switches when the logic level of the signal changes, thereby connecting the generator to the other transistor. As ECL logic is used, the switching of CM can be very fast and simultaneous with the switching of transistors T3, T4.

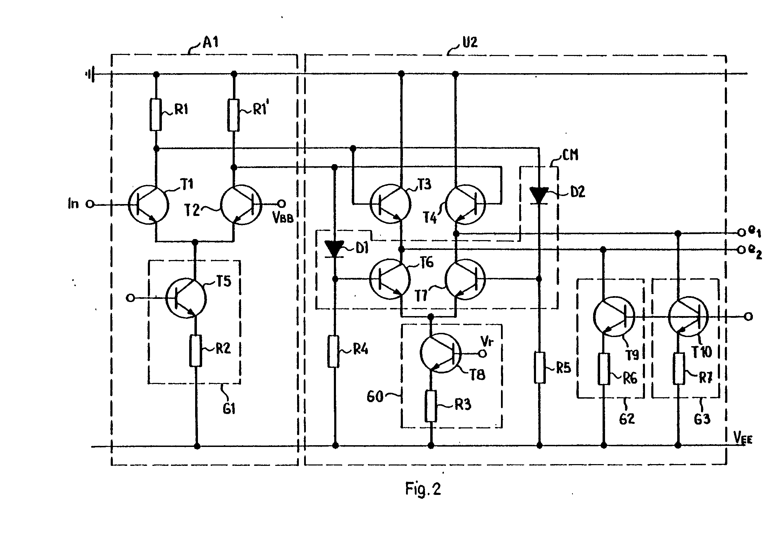

Figure 2 shows a circuit diagram of the invention. In this case voltage levels to send over the line are just ECL levels. As to input amplifier A1, generator G1 has been represented in details, which generator consists of transistor T5 and resistor R2. In output stage U2, the emitters of transistors T3, T4 are connected to the collectors of a pair of transistors T6, T7 of which the emitters are connected to the collector of a further transistor T8 which together with resistor R3 forms generator G0. The bases of T6, T7 are connected through diodes D1, D2 to the collectors of T2, T1 respectively; the cross-connection between T1, T2 and T6, T7 (i.e. the connection such that T1 drives transistor T7, connected to T4, and T2 drives transistor T6, connected to T3) allows, as will be seen hereinafter, current I0 to be supplied to the transistor which sends the low-level signal on the line.

Diodes D1, D2 are connected to bias resistors R4, R5 and are inserted so that they are always conducting; their task is to shift the voltage levels at the bases of transistors T6, T7 so as to ensure driving of the transistors while inhibiting their saturation and without attenuating the signal present on the collectors of T1, T2. Two further current generators G2, G3, consisting respectively of transistors T9, T10 and resistors R6, R7, are connected to the emitters of T3, T4 and supply a bias current I2, which is much lower than that supplied by G0 (e.g. 1 mA), so as to prevent the cut-off of T3, T4, when they are not connected to G0. To allow different driving requirements (different line impedances, different operating speeds, and so on) to be met, generator G0 can be programmed at a predetermined value, by presetting the reference voltage $V_r$, applied to the basis of T8, in a manner well-known to the person skilled in the art.

The operation of the circuit of Figure 2 will now be described supposing that generators G1, G2, G3 supply a current of the order of 1 mA, that the resistance of R1, R1' is of the order of 800 $\Omega$ and the voltage values are $-0.8$ V for the high logic level, $-1.6$ V for the low logic level and $-1.2$ V for $V_{BB}$. By supposing that a signal at low level is present at In, current I1 supplied by G1 passes through transistor T2, while T1 is cut-off.

As a consequence the collector of T1 and hence the basis of T3 are substantially grounded, while the collector of T2 and the basis of T4 are at $-0.8$ V.

Voltages of $-0.8$ V (high level) and $-1.6$ V (low level) will be present emitters of T3, T4 respectively and hence at outputs e1, e2, towards the line to be driven. Under the assumption of a voltage drop across diodes D1, D2 of the order of 0.7 V, the basis of T6 passes to $-1.5$ V and the basis of T7 to $-0.7$ V. T6 is then cut off, and the current supplied by G0 passes through transistor T7 and is supplied to T4, which sends the low-level signal over the line.

When the signal at input In becomes high, the situation is reversed; T6 conducts and supplies current I0 to T3, which sends the low-level signal over the line, while T7 becomes cut off, thereby disconnecting T4 from G0.

For a correct circuit operation the switching of transistors T6, T7 must be substantially simultaneous with that of T3, T4. In the circuit shown, this is certainly obtained, since T3, T4 and T6, T7 are driven by the same signal, as diodes D1, D2 are always conducting.

In addition, when the circuit is unloaded, the output impedances (impedances presented by the transistors as viewed from the emitters) are considerably low and hence the switching of T6, T7 causes no disturbances; therefore at the output there are the waveforms typical of ECL logic.

In addition, due to the balanced arrangement of transistors T6, T7, thermal drifts (as those of diodes D1, D2) are compensated for and do not affect the output signals.

Under stationary conditions the power consumption will be $(I0+2 \cdot I2) \cdot V_{EE}$, i.e., with the above-mentioned values, 60 mW. The current delivered by the transistor which sends the high-level signal will be $I_L+I2$, i.e. about 11 mA.

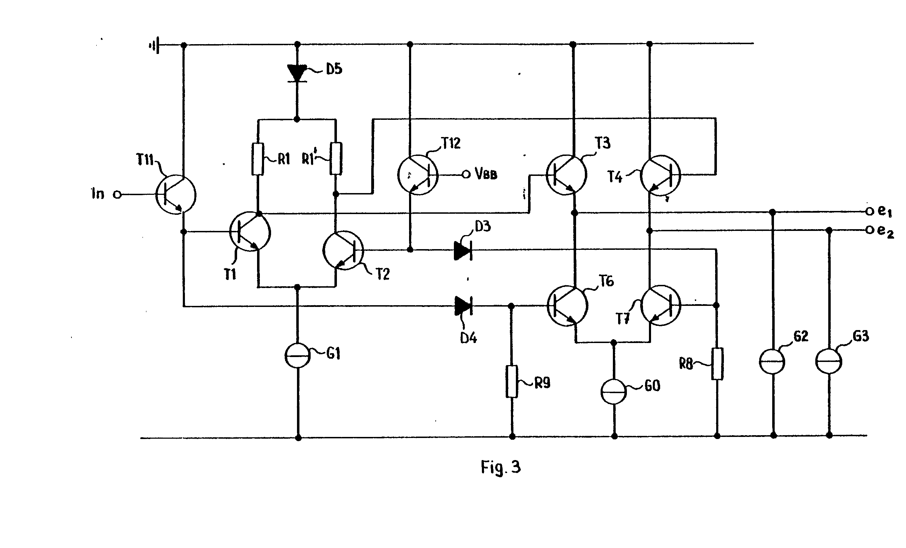

Figure 3 shows a variant embodiment apt to drive lines which do not require ECL logic levels, but more symmetrical levels in respect of supply; the elements which have already been described with reference to Figure 2 are denoted by the same reference symbols.

In this variant embodiment, the bases of transistors T6, T7 are connected through diodes D3, D4, analogous to D1, D2, to the emitters of a pair of common-collector transistors T11, T12, which drive transistors T1, T2.

Diodes D3, D4 are associated with resistors R9, R8 analogous to R4, R5. A further diode D5 causes the level shift at the collectors of T1, T2. To make the drawing simpler, generators G0—G3 are not shown in details.

To describe the operation of the circuit of Figure 3 it will be supposed that $-1.6$ V and $-2.4$ V voltages are desired at outputs e1, e2, for the high and the low level respectively; diode D5 is then to cause a voltage drop of about 0.8 V to give the corresponding level shift with respect to ECL levels.

The operation is then the following: by applying, for instance, a low-level signal ($-1.6$ V) to In, the basis of T1 is at about $-2.3$ V and the basis of T2, as an effect of voltage $V_{BB}$ applied to the base of T12, passes to $-1.9$ V. The whole of current I1 passes through T2 and the collector of T1 passes to a voltage corresponding to the drop across D5, i.e. $-0.8$ V.

As in the circuit of Figure 2, low and high levels will be present at outputs e2,e1 respectively, such levels being respectively in this case $-1.6$ V and $-2.4$ V.

Under the described conditions, and taking into account the voltage drops across D3, D4 (which are supposed to be equal to those across D1, D2) the basis of T6 passes to $-3$ V and that of T7 to $-2.6$ V, hence current I0 passes through T7 and is supplied to transistor T4 which emits the low level signal.

With a high level signal the situation reverses; with respect to the diagram of Figure 2 there is the difference that the voltage at the base of T7 remains unchanged, as it depends on voltage $V_{BB}$ which is constant, while the voltage at the base of T6 passes to $-2.2$ V.

Also this arrangement ensures that no delays occur in the switching of T6, T7 with respect to T3, T4; indeed, as T6, T7 are driven by signals extracted upstream those which drive T3, T4, the switching of the latter could even be shortly delayed wth respect to that of T6, T7.

An arrangement like that of Figure 3 presents the advantage that it does not load the collectors of T1, T2 to drive T6, T7.

## Claims

1. A driving circuit for high-speed digital-signal transmission lines, comprising an input stage (A1) consisting of a first and a second transistor (T1, T2) and a current generator (G1), said transistors and generator being connected so as to form a first differential amplifier, and an output stage (U2) comprising a third and a fourth transistor (T3, T4) with common collector, having the emitters connectable to the two wires of the transmission line, the basis connected to the collectors of the first and second transistors (T1, T2) respectively and the emitters connectable to a common bias-current generator (G0) through a switching circuit (CM) which connects the common generator (G0) to either the third or the fourth transistor (T3, T4) depending on which transistor is sending a signal at low logic level on the line, and which comprises a fifth and a sixth transistor (T6, T7) having the collectors connected to the emitters of the third and fourth transistors (T3, T4), respectively, and the emitters connected to said common generator (G0), the fifth and sixth transistors being driven so that their saturation is prevented, characterized in that said fifth and sixth transistors (T6, T7) are driven by the input stage through a first and a second diode (D1, D2) connected, so as to be always conducting, between the bases of said fifth and sixth transistor and the collectors of the second and first transistor (T2, T1), respectively, said first and second diodes (D1, D2) being associated with bias resistors (R4, R5) which shift the voltage levels present at the collectors of the first and second transistors by the extent required to prevent said saturation.

2. A driving circuit for high-speed digital-signal transmission lines, comprising an input stage (A1) consisting of a first and a second transistor (T1, T2) and a current generator (G1), said transistors and generator being connected so as to form a first differential amplifier, and an output stage (U2) comprising a third and a fourth transistor (T3, T4) with common collector, having the emitters connectable to the two wires of the transmision line, the bases connected to the collectors of the first and second transistors (T1, T2) respectively and the emitters connectable to a common bias-current generator (G0) through a switching circuit (CM) which connects the common generator (G0) to either the third or the fourth transistor (T3, T4) depending on which transistor is sending a signal at low logic level on the line, and which comprises a fifth and a sixth transistor (T6, T7), having the collectors connected to the emitters of the third and fourth transistors (T3, T4) respectively, and the emitters connected to said common generator (G0), the fifth and sixth transistors being driven so that their saturation is prevented, characterized in that, for driving lines requiring voltage levels shifted with respect to the ECL levels, said fifth and sixth transistors (T6, T7) are driven by the input stage through a third and fourth diode (D3, D4) connected, so as to be always conducting, between the bases of said fifth and sixth transistors and the emitters of a seventh and eighth transistor (T11, T12) with common collector, which transistors drive said first and second transistors (T1, T2) and have the bases connected to the signal input (In) and to an intermediate voltage ($V_{BB}$) between the voltages corresponding to the low and high logic levels, respectively, said third and fourth diodes (D3, D4) being associated with bias resistors (R8, R9) which shift the voltage levels present at the emitters of the seventh and eighth transistors by the extent required to prevent said saturation, a fifth diode being provided to shift as required the voltage levels present at the collectors of the first and second transistors.

3. Driving circuit according to Claim 1 or 2, characterized in that it comprises also two further bias current generators (G2, G3) which are connected to the emitters of the third and fourth transistor (T3, T4) respectively and supply a considerably lower current than that of the common generator (G0), to prevent the inhibition of the transistor which receives no current from the common generator (G0).

4. Driving circuit according to any one of the preceding claims, characterized in that said common generator (G0) is programmable.

## Patentansprüche

1. Treiberschaltung für Leitungen zum Übertragen von Digitalsignalen mit hoher Geschwindigkeit, mit einer Eingangsstufe (A1), die aus einem ersten und einem zweiten Transisor (T1, T2) und einem Stromgenerator (G1) besteht, die als erster Differenzverstärker geschaltet sind, und mit einer Ausgangsstufe (U2), die einen dritten und einen vierten Transistor (T3, T4) in Kollektorschaltung enthält, deren Emitter mit den beiden Leitern der Übertragungsleitung verbindbar sind, während die Basen mit den Kollektoren des ersten bzw. zweiten Transistors (T1, T2) verbunden sind und die Emitter noch mit einem gemeinsamen Vorbelastungsstromgenerator (G0) über eine Umschaltschaltung (CM) verbindbar sind, die den gemeinsamen Generator (G0) in Abhängigkeit davon, welcher Transistor gerade ein Signal niedrigen logischen Pegels auf die Leitung sendet, entweder mit dem dritten oder mit dem vierten Transistor (T3, T4) verbindet und selbst einen fünften und einen sechsten Transistor (T6, T7) umfaßt, deren Kollektoren mit den Emittern des dritten bzw. vierten Transistors (T3, T4) und deren Emitter mit dem gemeinsamen Generator (G0) verbunden sind und die so angesteuert sind, daß sie nicht in Sättigung geraten, dadurch gekennzeichnet, daß der fünfte und der sechste Transistor (T6, T7) durch die Eingangsstufe über eine erste und eine zweite Diode (D1, D2) angesteuert sind, die so, daß sie ständig leiten, zwischen die Basen des fünften bzw. sechsten Transistors und die Kollektoren des zweiten bzw. ersten Transistors (T2, T1) geschaltet sind und mit Vorbelastungswiderständen (R4, R5) verbunden sind, die die an den Kollektoren des ersten und des zweiten Transistors liegenden Spannungspegel um das zur Verhinderung der Sättigung notwendige Maß verschieben.

2. Treiberschaltung für Leitungen zum Übertragen von Digitalsignalen mit hoher Geschwindigkeit, mit einer Eingangsstufe (A1), die aus einem ersten und einem zweiten Transistor (T1, T2) und einem Stromgenerator (G1) besteht, die als erster Differenzverstärker geschaltet sind, und mit einer Ausgangsstufe (U2), die einen dritten und einen vierten Transistor (T3, T4) in Kollektorschaltung enthält, deren Emitter mit den beiden Leitern der Übertragungsleitung verbindbar sind, während die Basen mit den Kollektoren des ersten bzw. zweiten Transistors (T1, T2) verbunden sind und die Emitter noch mit einem gemeinsamen Vorbe- lastungsstromgenerator (G0) über eine Umschalt- schaltung (CM) verbindbar sind, die den gemein- samen Generator (G0) in Abhängigkeit davon, welcher Transistor gerade ein Signal niedrigen logischen Pegels auf die Leitung sendet, entweder mit dem dritten oder mit dem vierten Transistor (T3, T4) verbindet und selbst einen fünften und einen sechsten Transistor (T6, T7) umfaßt, deren Kollektoren mit den Emittern des dritten bzw. vierten Transistors (T3, T4) und deren Emitter mit dem gemeinsamen Generator (G0) ver- bunden sind und die so angesteuert sind, daß sie nicht in Sättigung geraten, dadurch gekennzeichnet, daß zum Treiben von Leitungen die in Bezug zu den ECL-Pegeln verschobene Spannungspegel erfordern, der fünfte und der sechste Transistor (T6, T7) durch die Eingangsstufe über eine dritte und eine vierte Diode (D3, D4) angesteuert sind, die so, daß sie ständig leiten, zwischen die Basen des fünften und sechsten Transistors und die Emitter eines siebten und achten Transistors (T11, T12) geschaltet sind, welche letztere Kollektorschaltung aufweisen, den ersten und den zweiten Transistor (T1, T2) treiben und mit der Basis an einen Signaleingang (In) bzw. an eine Zwischenspannung (V$_{BB}$) zwischen den dem hohen und dem niedrigen logischen Pegel entsprechenden Spannungen angelegt sind, wobei die dritte und die vierte Diode (D3, D4) mit Vorbelastungswiderständen (R8, R9) verbunden sind, die die an den Emittern des siebten und achten Transistors liegenden Spannungspegel umd das zur Verhinderung der Sättigung notwendige Maß verschieben, und wobei eine fünfte Diode (D5) dazu dient, die an den Kollektoren des ersten und zweiten Transistors vorliegenden Spannungspegel im erforderlichen Maß zu verschieben.

3. Treiberschaltung nach Anspruch 1 oder 2, dadurch gekennzeichnet, daß sie weiterhin zwei Vorbelastungs-Stromgeneratoren (G2, G3) umfaßt, die mit den Emittern des dritten bzw. vierten Transistors (T3, T4) verbunden sind und einen wesentlich niedrigeren Strom als der gemeinsame Generator (G0) liefern, um die Sper- rung des Transistors zu verhindern, der keinen Strom vom gemeinsamen Generator (G0) emp- fängt.

4. Treiberschaltung nach einem der vorhergehenden Ansprüche, dadurch gekennzeichnet, daß der gemeinsame Generator (G0) programmierbar ist.

**Revendications**

1. Circuit pilote pour lignes de transmission de signaux numériques à vitesse élevée, comprenant un étage d'entrée (A1) constitué par un premier et un deuxième transistor (T1, T2) et par un générateur de courant (G1), les transistors et le générateur étant connectés de manière à constituer un premier amplificateur différentiel, et un étage de sortie (U2) comprenant un troisième et un quatrième transistor (T3, T4), à collecteur commun, dont les émetteurs sont connectables aux deux fils de la ligne de transmission, les bases sont connectées aux collecteurs du premier et du deuxième transistor (T1, T2), respectivement, et les émetteurs sont connectables à un générateur commun de courant de polarisation (G0) à l'aide d'un circuit de commutation (CM), qui connecte le générateur commun (G0) au troisième ou au quatrième transistor (T3, T4) suivant que l'un ou l'autre des deux transistors soit en train d'envoyer sur la ligne un signal à niveau logique bas, et qui comprend un cinquième et un sixième transistor (T6, T7) dont les collecteurs sont respectivement connectés aux émetteurs du troisième et du quatrième transistor (T3, T4) et les émetteurs sont connectés audit générateur commun (G0), le cinquième et le sixième transistor étant pilotés de façon à empêcher leur saturation, caractérisé en ce que le cinquième et sixième transistor (T6, T7) sont pilotés par l'étage d'entrée à l'aide d'une première et d'une deuxième diode (D1, D2) connectées, de manière a être toujours en conduction, entre les bases du cinquième et du sixième transistor et les collecteurs du deuxième et du premier transistor (T2, T1), respectivement, la première et la deuxième diode (D1, D2) étant associées avec des résistances de polarisation (R4, R5) qui déplacent les niveaux de tension présents aux collecteurs du premier et du deuxième transistor dans la mesure nécessaire à empêcher ladite saturation.

2. Circuit pilote pour lignes de transmission de signaux numériques à vitesse élevée, comprenant un étage d'entrée (A1) constitué par un premier et un deuxième transistor (T1, T2) et par un générateur de courant (G1), les transistors et le générateur étant connectés de manière à constituer un premier amplificateur différentiel, et un étage de sortie (U2) comprenant un troisième et un quatrième transistor (T3, T4), à collecteur commun, dont les émetteurs sont connectables aux deux fils de la ligne de transmission, les bases sont connectées aux collecteurs du premier et du deuxième transistor (T1, T2), rspectivement, et les émetteurs sont connectables à un générateur commun de courant de polarisation (G0) à l'aide d'un circuit de commutation (CM), qui connecte le générateur commun (G0) au troisième ou au quatrième transistor (T3, T4) suivant que l'une ou l'autre des deux transistors soit en train d'envoyer sur la ligne un signal à niveau logique bas, et qui comprend un cinquième et un sixième transistor (T6, T7) dont les collecteurs sont respectivement connectés aux émetteurs du troisième et du quatrième transistor (T3, T4) et les émetteurs sont connectés audit générateur commun (G0), le cinquième et le sixième transistor étant pilotés de façon à empécher leur saturation, caractérisé en ce que, pour le pilotage de lignes qui demandent des niveaux de tension déplacés par rapport aux niveaux ECL, le cinquième et le sixième transistor (T6, T7) sont pilotés par l'étage d'entrée à l'aide d'une troisième et d'une quatrième diode (D3, D4) connectées, de manière a être toujours en conduction, entre les bases du cinquième et du sixième transistor et les émetteurs d'un septième et d'un huitième transistor (T11, T12), à collecteur commun, qui pilotent le premier et le deuxième transistor (T1, T2) et dont les bases sont respectivement connectées à l'entrée des signaux (In) et à une tension ($V_{BB}$) intermédiaire entre les tensions correspondant aux niveaux logiques bas et haut, la troisième et la quatrième diode (D3, D4) étant associées à des résistances de polarisation (R8, R9) qui déplacent les niveaux de tension présents aux émetteurs du septième et du huitième transistor (T11, T12) dans la mesure nécessiare à empécher ladite saturation, une cinquième diode (D5) étant présente pour déplacer dans la mesure démandée les niveaux de tension présents aux collecteurs du premier et du deuxième transistor.

3. Circuit pilote suivant la revendication 1 ou 2, caractérisé en ce qu'il comprend en outre deux autres générateurs de courant de polarisation (G2, G3), qui sont connectés respectivement aux émetteurs du troisième et du quatrième transistor (T3, T4) et qui fournissent un courant considérablement plus faible que le courant du générateur commun (G0), pour empécher le blocage du transistor qui ne reçoit pas de courant du générateur commun (G0).

4. Circuit pilote suivant l'une quelconque des revendications précédentes, caractérisé en ce que le générateur commun (G0) est programmable.

Fig. 1

Fig. 2

Fig. 3